# EUROPÄISCHE PATENTSCHRIFT

(11) **EP 2 009 673 B1**
(45) Veröffentlichungstag und Bekanntmachung des Hinweises auf die Patenterteilung: **02.03.2011**
(21) Anmeldenummer: 08104354.9
(22) Anmeldetag: 11.06.2008
(51) Int. Cl.: H01L 21/00, B23K 1/20, B23K 3/08, B23K 3/06

(54) **Vorrichtung zur Herstellung von Flüssigkeitsschichten mit vorbestimmter Dicke auf einem Träger**
Method for manufacturing fluid layers with pre-determined thickness on a framework
Dispositif de fabrication de couches de liquides dotées d'épaisseurs prédéfinies sur un support

(30) Priorität: 27.06.2007 DE 102007029725
(43) Veröffentlichungstag der Anmeldung: 31.12.2008
(73) Patentinhaber: Siemens Electronics Assembly Systems GmbH & Co. KG, 81379 München (DE)
(72) Erfinder: Niedermeier, Michael, 82049, Pullach (DE); Daschner, Christian, 93413 Cham (DE); Zeiger, Thomas, 6134, Vomp (AT); Eschenweck, Friedrich, 85622, Feldkirchen (DE)

(56) Entgegenhaltungen:
- EP-A2- 2 009 674
- US-B1- 6 293 317

## Beschreibung

Die vorliegende Erfindung betrifft eine Vorrichtung zur Herstellung von Flüssigkeitsschichten mit vorbestimmter Dicke auf einem Träger, umfassend
eine Flüssigkeits-Trägerplatte, und
einen Flüssigkeitsbehälter, der zum Aufbringen einer Flüssigkeitsschicht auf einer Oberfläche der Flüssigkeits-Trägerplatte über die Flüssigkeits-Trägerplatte bewegbar ist oder bewegt wird.

Derartige Vorrichtungen sind aus dem Stand der Technik bekannt. So offenbart das US-Patent US 6,293,317 B1 eine Vorrichtung zur Herstellung von Flüssigkeitsschichten innerhalb von Öffnungen einer Trägerplatte, bei welchen ein Flüssigkeitsbehälter über die Trägerplatte mit den Öffnungen bewegt wird und dabei innerhalb der Öffnungen Flüssigkeitsschichten erzeugt werden. Es ist ein Nachteil des genannten Standes der Technik, dass die Dicke der Flüssigkeitsschicht durch die Tiefe der Öffnungen innerhalb der Trägerplatte festgelegt ist. Bei bestimmten Anwendungen der Flüssigkeiten ist es allerdings erforderlich, dass die Dicke der Flüssigkeitsschicht flexibel anpassbar ist. So ist es beispielsweise beim Benetzen von elektrischen Kontakten von Bauelementen mit Flussmittel oder Lotpaste notwendig, die Schichtdicke der Flussmittelschicht abhängig beispielsweise von der Größe der Kontakte einzustellen. Daher ist die in US 6,293,317 B1 beschriebene Anordnung nur für ganz bestimmte Bauelemente bzw. Bauelement-Größen gut geeignet. Bauelemente mit beispielsweise zu kleinen oder zu großen Kontakten können mit einer solchen Vorrichtung nur schlechter oder gar nicht bearbeitet werden.

Daher ist es eine Aufgabe der vorliegenden Erfindung, eine Vorrichtung zur Herstellung von Flüssigkeitsschichten zur Verfügung zu stellen, welche besser an unterschiedliche Anwendungen der Flüssigkeitsschichten angepasst sind.

Diese Aufgabe wird gelöst von einer Vorrichtung zur Herstellung von Flüssigkeitsschichten mit vorbestimmter Dicke auf einem Träger, umfassend
eine Flüssigkeits-Trägerplatte, und
einen Flüssigkeitsbehälter, der zum Aufbringen einer Flüssigkeitsschicht auf einer Oberfläche der Flüssigkeits-Trägerplatte über die Flüssigkeits-Trägerplatte bewegbar ist oder bewegt wird,
wobei ein Hubmechanismus vorgesehen ist, mit welchem die Oberfläche der Trägerplatte relativ zu einer Unterkante des Flüssigkeitsbehälters verschiebbar ist,
und wobei die Verschiebung eine Bewegungskomponente senkrecht zur Oberfläche der Flüssigkeits-Trägerplatte aufweist, insbesondere, dass die Verschiebung im Wesentlichen senkrecht zur Oberfläche der Flüssigkeits-Trägerplatte verläuft.

Da bei der Schichtherstellung der Flüssigkeitsbehälter über die Oberfläche der Flüssigkeits-Trägerplatte bewegt wird ergibt es sich, dass die Schichtdicke im Zusammenhang mit der räumlichen Lage des Flüssigkeitsbehälters sowie der Oberfläche der Flüssigkeits-Trägerplatte steht. Daher lässt sich durch eine Verschiebung der Flüssigkeits-Trägerplatte relativ zum Flüssigkeitsbehälter gemäß dem vorstehenden Absatz durch diese Bewegung ein Einfluss beispielsweise auf die Schichtdicke einer aufgebrachten bzw. aufzubringenden Flüssigkeits-schicht herstellen. Dadurch ist beispielsweise die Schichtdicke mittels des genannten Hubmechanismus beeinflussbar. Auf diese Weise kann zum Beispiel die Dicke einer aufgebrachten Flüssigkeitsschicht besser beispielsweise an ein mit der Flüssigkeit zu benetzendes Element angepasst werden. Somit wird auf diese Weise eine verbesserte Anpassbarkeit der Vorrichtung zur Herstellung von Flüssigkeitsschichten an verschiedene Anwendungen erreicht.

Außer dass die Schichtdicke einer aufzubringenden oder aufgebrachten Flüssigkeitsschicht im Zusammenhang mit der räumlichen Lage des Flüssigkeitsbehälters zu der Oberfläche der Flüssigkeits-Trägerplatte steht, kann diese Dicke noch von weiteren Parametern wie z.B. den physikalisch-chemischen Eigenschaften der Flüssigkeit, wie z.B. Oberflächenspannung und Zähigkeit, abhängen. Diese zusätzlichen Abhängigkeiten sollen aber im Rahmen der vorliegenden Beschreibung außer Betracht bleiben.

Flüssigkeiten zur Verwendung mit der Vorrichtung können beispielsweise Flussmittel, Lotpasten, Kleber, Wärmeleitpasten, Leitpasten oder andere Flüssigkeiten sein, insbesondere Flüssigkeiten mit relativ hoher Viskosität.

Die Oberfläche der Flüssigkeits-Trägerplatte kann zumindest einen im Wesentlichen ebenen Bereich aufweisen, auf welchem die Flüssigkeitsschicht aufgebracht oder aufbringbar ist. Weiterhin kann sich die Oberfläche der Flüssigkeits-Trägerplatte zum Aufbringen der Flüssigkeitsschicht aus mehreren im Wesentlichen ebenen Bereichen, insbesondere mehreren getrennten ebenen Bereichen, zusammensetzen. Zudem kann auch die gesamte Oberseite zur Aufnahme einer Flüssigkeitsschicht im Wesentlichen eben sein. Wenn die Oberfläche der Flüssigkeits-Trägerplatte mehrere ebene Oberflächenbereiche, insbesondere mehrere getrennte ebene Oberflächenbereiche, umfasst, können alle diese Bereiche eine identische Höhenlage oder auch verschiedene Höhenlagen (z.B. zur Herstellung von Schichten mit verschiedenen Dicken in einem Arbeitsgang) aufweisen.

Es kann bei der Flüssigkeits-Trägerplatte beispielsweise ein schmaler Randbereich vorgesehen sein, in welchem beispielsweise eine Nut zur Aufnahme von Flüssigkeitsresten oder auch eine Erhöhung zur Begrenzung und/oder Stabilisierung der Flüssigkeit vorgesehen sein kann. Eine solche Erhöhung kann dabei auch z.B. niedriger als die Dicke einer aufgebrachten oder aufzubringenden Flüssigkeitsschicht sein.

Weiterhin kann die Vorrichtung entlang von zumindest Teilen der Ränder der Flüssigkeits-Trägerplatte eine Außenbegrenzung für die aufgebrachte oder aufzubringende Flüssigkeitsschicht umfassen, wobei die Flüssigkeits-Trägerplatte relativ zur Außenbegrenzung bewegbar ist.

Die Bewegung des Flüssigkeitsbehälters über die Flüssigkeits-Trägerplatte kann beispielsweise im Wesentlichen parallel zur Oberfläche der Flüssigkeits-Trägerplatte und/oder entlang der Oberflächen der Flüssigkeits-Trägerplatte erfolgen. Zur Herstellung der Flüssigkeitsschicht kann der Flüssigkeitsbehälter zumindest über Teile der Flüssigkeits-Trägerplatte bewegt werden oder auch über die gesamte, zur Aufbringung der Flüssigkeitsschicht vorgesehene Oberfläche der Flüssigkeits-Trägerplatte bewegt werden. Weiterhin kann der Flüssigkeitsbehälter auch, ausgehend von einer Ausgangsstellung, in einer Hin- und Rück-Bewegung zur Aufbringung der Flüssigkeits-schicht im Wesentlichen zweimal über die Oberfläche der Flüssigkeits-Trägerplatte bewegt werden.

Eine aufgebrachte Flüssigkeitsschicht kann beispielsweise teilweise oder auch vollständig durch ihre Oberflächenspannung stabilisiert sein. Weiterhin kann eine aufgebrachte Flüssigkeitsschicht auch teilweise oder vollständig durch eine mechanische Begrenzung (z.B. eine Seitenwand) stabilisiert sein.

Weiterhin kann der Flüssigkeitsbehälter derart ausgebildet sein, dass er einen Flüssigkeitsaufbewahrungsbereich aufweist, der mit einer Öffnung an einer Unterseite des Flüssigkeitsbehälters verbunden ist. Dabei kann der Flüssigkeitsbehälter weiterhin so ausgebildet sein, dass bei der Bewegung des Flüssigkeitsbehälters über die Oberfläche der Flüssigkeits-Trägerplatte die Flüssigkeitsschicht durch das Austreten der Flüssigkeit aus der Öffnung an der Unterseite des Flüssigkeitsbehälters gebildet wird. Auf diese Weise ergibt sich eine einfache und mechanisch gut herstellbare Ausgestaltungsmöglichkeit der genannten Vorrichtung.

Eine Vorrichtung gemäß der vorangehenden Beschreibung kann beispielsweise weiterhin derart ausgebildet sein, dass eine Dicke der aufzubringenden Flüssigkeitsschicht mittels des Hubmechanismus zwischen einem vorgegebenen oder vorgebbaren minimalen und einem vorgegebenen oder einem vorgebbaren maximalen Dickenwert kontinuierlich einstellbar ist oder eingestellt wird. Der minimale Dickenwert kann dabei null oder auch eine von null verschiedene minimale Schichtdicke sein. Damit lässt sich die Flexibilität bei der Anpassung der hergestellten Flüssigkeitsschichten an entsprechend mit den Flüssigkeitsschichten zu verwendende Elemente weiter verbessern, da, zumindest innerhalb eines Größenbereichs, die Dicke einer Flüssigkeitsschicht genau an entsprechend durch die mit der Schicht zu verwendenden Elemente vorgegebenen Randbedingungen angepasst werden kann. So kann beispielsweise bei einer Vorrichtung zur Präsentation von Flussmittelschichten für elektrische Kontaktbereiche von Bauelementen die Dicke der Flussmittelschicht genau an die Ausdehnung, wie z.B. die Länge, der elektrischen Kontakte angepasst werden.

Die Dicke der aufzubringenden Flüssigkeitsschicht kann beispielsweise dem Abstand der Unterkante des Flüssigkeitsbehälters zu der Oberfläche der Flüssigkeits-Trägerplatte entsprechen, insbesondere dem vertikalen Abstand der Unterkante des Flüssigkeitsbehälters zu der Oberfläche der Flüssigkeits-Trägerplatte. So kann der genannte Abstand (z.B. der vertikale Abstand) zwischen der Unterkante des Flüssigkeitsbehälters und der Oberfläche der Flüssigkeits-Trägerplatte insbesondere eine Höhendifferenz zwischen der Unterkante des Flüssigkeitsbehälters und der Oberfläche der Flüssigkeits-Trägerplatte sein.

Wie bereits erläutert, kann die Flüssigkeits-Trägerplatte eine Erhöhung zur Begrenzung und/oder Stabilisierung der Flüssigkeitsschicht umfassen. Im vorstehend genannten Fall kann eine solche Erhöhung z.B. dem minimalen Dickenwert entsprechen oder auch niedriger sein. In diesem Fall würde die hergestellte Schicht dann im Allgemeinen teilweise durch die als Erhöhung ausgebildete mechanische Begrenzung und teilweise durch ihre Oberflächenspannung stabilisiert.

Diese genannte Ausgestaltung ermöglicht insbesondere auch in Kombination mit dem vorstehend genannten Flüssigkeitsbehälter mit nach unten geöffnetem Vorratsraum eine besonders einfache und flexible Vorrichtung zur Herstellung von Flüssigkeitsschichten.

Weiterhin kann die Flüssigkeits-Trägerplatte derart ausgestaltet sein, das keine vertikal über die Oberfläche hinausragenden Seitenelemente zur Begrenzung der aufgebrachten oder aufzubringenden Flüssigkeitsschicht aufweist. Bei dieser Ausgestaltung kann beispielsweise vorgesehen sein, dass die aufgebrachte Flüssigkeitsschicht im Wesentlichen vollständig durch die Oberflächenspannung der Flüssigkeit stabilisiert wird. Die Flüssigkeits-Trägerplatte kann zusätzlich beispielsweise in Randbereichen Nuten oder Vertiefungen vorsehen, die zur Ableitung von Flüssigkeitsresten dienen können.

Als Oberfläche wird in diesem Zusammenhang derjenige Bereich der Flüssigkeits-Trägerplatte verstanden, auf welchem sich eine aufgebrachte oder aufzubringende Flüssigkeitsschicht befindet.

Mit dieser Ausgestaltung einer Flüssigkeits-Trägerplatte lassen sich besonders einfach Flüssigkeitsschichten mit kontinuierlichen Dickenwerten herstellen, da keine störend über die Oberfläche ragenden Elemente vorhanden sind, welche die Bewegung des Flüssigkeitsbehälters über die Trägerplatte einschränken. So würde beispielsweise ein Seitenelement zur Begrenzung der Flüssigkeitsschicht mit einer vorgegebenen Höhe erzwingen, dass der Flüssigkeitsbehälter mindestens mit dieser Höhe über der Oberfläche, auf welche die Flüssigkeit aufzubringen ist, über die Flüssigkeits-Trägerplatte bewegt werden muss.

Wenn im Rahmen der vorliegenden Beschreibung eine Bewegung des Flüssigkeitsbehälters über die Flüssigkeits-Trägerplatte beschrieben ist, so ist damit immer eine Relativbewegung des Flüssigkeitsbehälters und der Flüssigkeits-Trägerplatte gemeint. Das bedeutet, dass dabei sowohl sich der Flüssigkeitsbehälter über eine fixierte Flüssigkeits-Trägerplatte bewegen kann oder sich eine Flüssigkeits-Trägerplatte unter einem fixierten Flüssigkeitsbehälter hindurch bewegen kann.

Weiterhin kann die Vorrichtung ein Basiselement aufweisen, wobei das Basiselement beispielsweise zum Befestigen der Vorrichtung von einem Träger oder zum Befestigen der Vorrichtung an beispielsweise einer Basiseinheit eines Bestückautomaten ausgebildet sein kann. Ein solches Basiselement kann beispielsweise als ganz oder teilweise geschlossenes Gehäuse, als Grundeinheit, als Tragegestell, Träger-Einheit oder ähnliche mechanische Einheit ausgebildet sein.

Dabei kann die Vorrichtung z.B. derart ausgestaltet sein, dass bei der Verschiebung der Trägerplatte mit einer Bewegungskomponente senkrecht zur Oberfläche der Flüssigkeits-Trägerplatte diese relativ zur Basiseinheit bewegt wird und die Lage des Flüssigkeitsbehälters relativ zur Basiseinheit unverändert bleibt. Weiterhin kann auch vorgesehen sein, dass sich bei der genannten Verschiebung der Flüssigkeitsbehälter relativ zur Basiseinheit bewegt während die Lage der Flüssigkeits-Trägerplatte zur Basiseinheit unverändert bleibt. Mittels eines solchen Basiselements ergibt sich eine einfache Integrationsmöglichkeit der genannten Vorrichtung in eine größere Produktionsanlage, beispielsweise einen Bestückautomaten zur Bestückung von Substraten mit Bauelementen oder einer entsprechenden Produktionsanlage oder -line (z.B. einer Bestücklinie).

Der Hubmechanismus kann derart ausgestaltet sein, dass er eine Antriebseinheit zur Bewegung der Flüssigkeits-Trägerplatte umfasst. Dabei kann die Antriebseinheit beispielsweise ein Motor, z.B. ein Elektromotor, oder auch eine pneumatisch oder hydraulisch angetriebene Antriebseinheit sein. Die Antriebseinheit kann dabei beispielsweise an dem Basiselement fixiert werden oder sein. Ein derart ausgestalteter Hubmechanismus ermöglicht eine einfache Ansteuerung oder Lageveränderung der Flüssigkeits-Trägerplatte, da z.B. keinerlei manuelle Eingriffe in die Vorrichtung zur Veränderung der Lage der Flüssigkeits-Trägerplatte notwendig sind.

Weiterhin kann der Hubmechanismus auch zur manuellen Einstellung der Lage der Flüssigkeits-Trägerplatte ausgebildet sein. Dies ermöglicht eine besonders günstige und einfache Konstruktion der beschriebenen Vorrichtung.

Der Hubmechanismus kann weiterhin ein durch die Antriebseinheit angetriebenes erstes Antriebselement und ein an der Flüssigkeits-Trägerplatte befindliches zweites Antriebselement umfassen, wobei das erste Antriebselement zur Bewegung der Flüssigkeits-Trägerplatte mit dem zweiten Antriebselement zusammenwirkt. Das erste und zweite Antriebselement kann jeweils beispielsweise als zumindest abschnittsweise keilförmig ausgebildetes Element ausgestaltet sind und/oder Rollen, Riemen, Getriebe oder ähnliche Elemente umfassen.

Das erste und zweite Antriebselement können dabei beispielsweise derart zusammenwirken, dass entsprechend passend zueinander orientierte Gleitflächen vorgesehen sind, wobei sich bei der Bewegung beider Antriebselemente die Gleitflächen aneinander vorbei bewegen. Dabei können die Gleitflächen als Gleitlager oder auch Rollenlager oder ähnliches ausgebildet sein. Diese Ausgestaltung ermöglicht eine mechanisch einfache und sehr genaue Konstruktion eines Hubmechanismus.

Das erste Antriebselement kann dabei zur Bewegung der Flüssigkeits-Trägerplatte im Wesentlichen parallel zu der Oberfläche der Flüssigkeits-Trägerplatte bewegt werden oder bewegbar sein. Das zweite Antriebselement kann dabei beispielsweise durch das erste Antriebselement senkrecht zur Oberfläche der Flüssigkeits-Trägerplatte bewegt werden oder bewegbar sein und somit eine Bewegung der Trägerplatte senkrecht zur Oberfläche der Flüssigkeitsträgerplatte bewirken. Auf diese Weise ergibt sich die Möglichkeit beispielsweise eine räumlich besonders kompakte Vorrichtung zur Herstellung von Flüssigkeitsschichten mit vorbestimmter Dicke auf einem Träger herzustellen, da beispielsweise der Bauraum unterhalb der Flüssigkeits-Trägerplatte für eine Bewegung des ersten Antriebselements genutzt werden kann.

Das erste und zweite Antriebselement können jeweils eine winklig zur Oberfläche der Flüssigkeits-Trägerplatte orientierte Gleitfläche aufweisen, wobei die Gleitflächen der zwei Antriebselemente derart aneinander angepasst, angeordnet und ausgestaltet sind, dass sie sich bei einer durch die Antriebseinheit bewirkten Bewegung der Flüssigkeits-Trägerplatte aneinander entlang bewegen. Wie vorstehend bereits erwähnt können solche Gleitflächen beispielsweise Gleitlager, Laufrollen oder Führungsschienen und entsprechenden Laufschlitten oder Rollen umfassen. Auch diese Ausgestaltung ermöglicht eine mechanisch einfache und trotzdem genaue Ausgestaltung eines Hubmechanismus.

Die vorstehend genannte Aufgabe wird weiterhin gelöst von einem Bestückautomaten zum Bestücken von elektrischen und/oder optischen Bauteilen auf Substrate, umfassend
einen Greifer zum Aufnehmen von elektrischen und/oder optischen Bauteilen aus einem Zuführbereich des Bestückautomaten und zum Absetzen der Bauteile auf einem Substrat, und eine Vorrichtung zur Herstellung von Flüssigkeitsschichten gemäß der vorstehenden Beschreibung,
wobei der Bestückautomat derart ausgebildet und eingerichtet ist, das zumindest Kontaktabschnitte der Bauteile nach dem Aufnehmen der Bauteile aus dem Zuführbereich und vor dem Absetzen auf dem Substrat unter Verwendung der Vorrichtung zur Herstellung von Flüssigkeitsschichten mit der Flüssigkeit benetzt werden oder benetzbar sind. Durch die Ausgestaltung der Vorrichtung gemäß der vorangegangenen Beschreibung ermöglicht auch ein solcher Bestückautomat eine verbesserte Anpassung der herzustellenden oder hergestellten Flüssigkeitsschichten an die Erfordernisse der jeweils eingesetzten Bauteile.

Kontaktabschnitte der Bauteile können dabei z.B. Abschnitte zur elektrischen und/oder mechanischen Verbindung der Bauteile mit einem Träger sein. Zur Herstellung einer elektrischen und u.U. gleichzeitig Mechanischen Verbindung können die Kontaktabschnitte beispielsweise metallische Kontakt-Pins, Kontakt-Kugeln und/oder Kontaktflächen sein, während die damit verwendeten Flüssigkeitsschichten z.B. aus Flussmittel oder Lotpaste bestehen können. Rein mechanische Verbindungen können beispielsweise unter Verwendung von Kleber-Flüssigkeitsschichten hergestellt werden.

Der Greifer des Bestückautomaten kann beispielsweise als Saugpipette oder mechanischer Greifer ausgebildet sein. Dabei kann beispielsweise weiterhin die Benetzung der Bauteile mit der Flüssigkeit durch eine entsprechende Bewegung des Greifers erreicht werden, beispielsweise indem der Greifer ein daran gehaltenes Bauteil über die Flüssigkeitsschicht bewegt und dann durch eine vertikale Bewegung zumindest teilweise in die Flüssigkeitsschicht eintaucht.

Dabei kann die Vorrichtung zur Herstellung von Flüssigkeitsschichten beispielsweise zumindest teilweise in dem Zuführbereich oder an einen Zuführbereich eines Bestückautomaten angrenzend angeordnet sein. Auf diese Weise können sich bei der Entnahme eines Bauteils aus dem Zuführbereich verkürzte Wege bis zum Benetzen des Bauteils ergeben, was die Bearbeitung und das Bestücken der Bauteile auf dem Substrat einfacher und schneller macht.

Die vorstehend genannte Aufgabe wird auch gelöst durch ein Verfahren zur Herstellung einer Flüssigkeitsschicht mit einer Vorrichtung zur Herstellung von Flüssigkeitsschichten gemäß der vorangehenden Beschreibung, bestehend aus den Schritten: Einstellen einer Dicke einer aufzubringenden Flüssigkeits-schicht mit dem Hubmechanismus,
Aufbringen der Flüssigkeitsschicht.
Durch die Möglichkeit die Schichtdicke der Flüssigkeits-schicht über den Hubmechanismus einstellen zu können ergibt sich eine vereinfachte Möglichkeit, die Dicke der Flüssigkeitsschicht an eine bestimmte Anwendung anzupassen.

Dabei kann die Dicke der aufzubringenden Flüssigkeitsschicht beispielsweise durch den Abstand der Unterkante des Flüssigkeitsbehälters zu der Oberfläche der Flüssigkeits-Trägerplatte bestimmt sein, insbesondere durch den vertikalen Abstand der Unterkante des Flüssigkeitsbehälters zu der Oberfläche der Flüssigkeits-Trägerplatte. So kann die Dicke der Flüssigkeitsschicht zum Beispiel dem Abstand der Unterkante des Flüssigkeitsbehälters zu der Oberfläche der Flüssigkeits-Trägerplatte entsprechen oder z.B. auch durch diesen Abstand bestimmt werden. Die Dicke der Flüssigkeitsschicht kann z.B. auch geringer als der genannte Abstand von Flüssigkeitsbehälter und Trägerplatten-Oberfläche sein, wobei einem Abstand von Flüssigkeitsbehälter und Trägerplatten-Oberfläche jeweils eine Schichtdicke der Flüssigkeits-Schicht zugeordnet ist.

Die vorstehend genannten Fälle können insbesondere z.B. bei Vorratsbehältern auftreten, bei welchen die Flüssigkeit bei der Herstellung der Flüssigkeitsschicht zumindest teilweise durch eine Öffnung an einer Unterseite des Behälters austritt. Dabei kann weiterhin die Dicke gegebenenfalls kontinuierlich zwischen einem maximalen und einem minimalen Dickenwert einstellbar sein. Mit diesen genannten Ausgestaltungsmöglichkeiten ergibt sich eine weiterhin verbesserte Anpassbarkeit der Flüssigkeitsschichten an beispielsweise damit zu benetzende Bauelemente.

Das genannte Verfahren kann weiterhin derart ausgebildet sein, das zum Aufbringen der Flüssigkeitsschicht der Flüssigkeitsbehälter über die Flüssigkeits-Trägerplatte bewegt wird. Hierzu lassen sich die im vorangegangenen Text diesbezüglich bereits angegebenen Erläuterungen und Ausgestaltungsmöglichkeiten ebenfalls anwenden. So kann z.B. der Behälter über die Platte oder die Platte unter dem Behälter hindurch bewegt werden.

Die vorstehend genannte Aufgabe wird weiterhin gelöst von einem Verfahren zum Bestücken von elektrischen und/oder optischen Bauteilen unter Verwendung eines Bestückautomaten gemäß der vorangegangenen Beschreibung, bestehend aus den Schritten:
Einstellen einer Dicke einer aufzubringenden Flüssigkeits-schicht mit dem Hubmechanismus,
Aufbringen der Flüssigkeitsschicht,
Eintauchen zumindest von Kontaktflächen eines mit dem Greifer aus dem Zuführbereich aufgenommenen Bauelements in die Flüssigkeitsschicht, und nachfolgend
Absetzen des Bauelements auf einem zu bestückendem Substrat.

Durch die Möglichkeit, die Dicke einer aufzubringenden Flüssigkeitsschicht einzustellen, ermöglicht dieses Verfahren ebenfalls eine verbesserte Anpassungsmöglichkeit der aufgebrachten Flüssigkeitsschicht z.B. an damit zu verwendende bzw. verwendete Bauelemente. Mögliche weitere Ausgestaltungen des Bestückautomaten können dabei gemäß der vorangegangenen Beschreibung erfolgen.

So kann beispielsweise wiederum die Dicke der aufzubringenden Flüssigkeitsschicht durch den Abstand der Unterkante des Flüssigkeitsbehälters zu der Oberfläche der Flüssigkeits-Trägerplatte bestimmt sein. Auch kann z.B. zum Aufbringen der Flüssigkeitsschicht der Flüssigkeitsbehälter über die Flüssigkeits-Trägerplatte bewegt werden, wobei wiederum z.B. der Behälter über die Platte oder die Platte unter dem Behälter hindurch bewegt werden kann.

Weitere Ausgestaltungsmöglichkeiten sind in den Unteransprüchen enthalten.

Im Folgenden wird die Erfindung beispielhaft mit Bezug auf die beiliegenden Figuren erläutert. Es zeigen:
Figur 1 Beispiel für eine Vorrichtung zur Herstellung von Flüssigkeitsschichten mit vorbestimmter Dicke;
Figur 2 die in Figur 1 dargestellte Vorrichtung zur Herstellung einer Schicht mit einer anderen Schichtdicke.

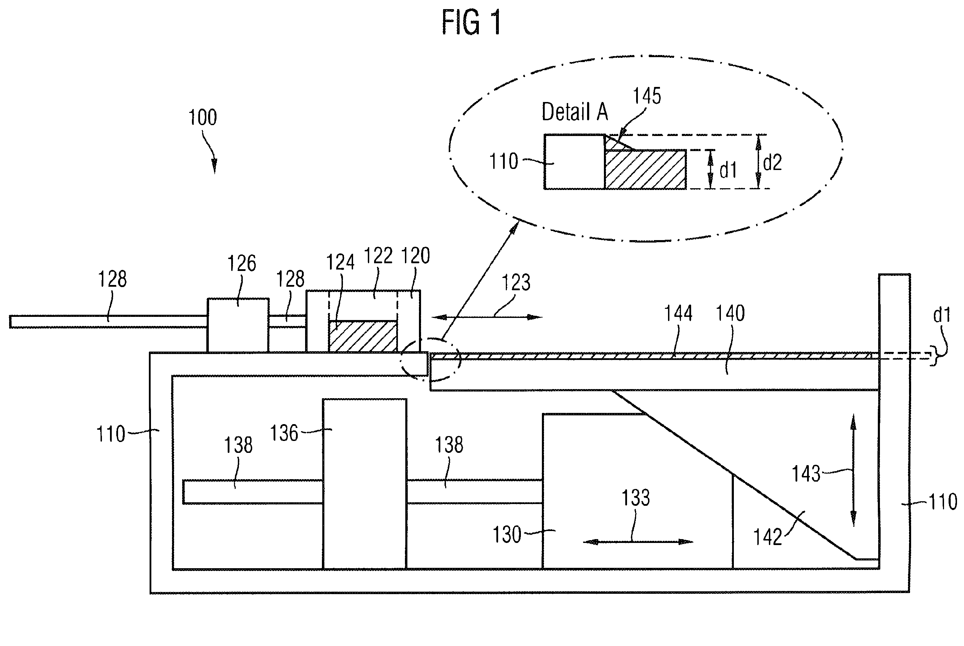

In Figur 1 ist eine Vorrichtung 100 zur Herstellung von Flussmittelschichten dargestellt. Die Vorrichtung 100 umfasst eine Trägerplatte 140, auf deren Oberfläche eine Flussmittelschicht 144 aufgebracht wurde. Zum Aufbringen der Flüssigkeitsschicht 144 ist ein Flussmittel-Vorrat 124 vorgesehen, welcher in einem Vorratsraum 122 eines Flussmittelbehälters 120 aufbewahrt wird. Der Vorratsraum 122 des Flussmittelbehälters 120 ist nach unten geöffnet, so dass bei einer Bewegung des Flussmittelbehälters 120 in einer durch den Pfeil 123 dargestellten Richtung über die Oberfläche der Trägerplatte 140 das Flussmittel 124 aus der unteren Öffnung des Vorratsraumes 122 austritt und so auf der Oberfläche der Trägerplatte 140 aufgebracht wird.

Die Flüssigkeitsschicht 144 weist eine Schichtdicke d1 auf, welche ebenfalls in Figur 1 eingezeichnet ist und welche sich aus einem in Detail A der Figur 1 gezeigten Abstand d2 der Oberfläche der Trägerplatte 140 und einer Unterkante des Flüssigkeitsbehälters 120 ergibt. Zum Aufbringen der Schicht wird der Flüssigkeitsbehälter 120 ausgehend von einer in Figur 1 dargestellten Ausgangsstellung in Richtung des Pfeils 123 ganz bis zum anderen Ende der Trägerplatte 140 bewegt und danach wieder zurück in die in Figur 1 dargestellte Ausgangsstellung gezogen.

Wie in Detail A in Figur 1 dargestellt, ist die Schichtdicke d1 der Flüssigkeitsschicht 144 im Allgemeinen kleiner als der Abstand d2 zwischen der Oberfläche der Trägerplatte 140 und der Unterkante des Flüssigkeitsbehälters 120. Dies wird z.B. durch Flüssigkeitsverschiebungen und -verluste nach dem Aufbringen der Flüssigkeitsschicht 144 verursacht. Wie in Detail A der Figur 1 ebenfalls dargestellt kann in einem Randbereich 145 der Flüssigkeitsschicht 144 die Dicke der Schicht 144 durch Benetzungseffekte von d1 aus anwachsen z.B. von d1 nach d2 anwachsen. Solche Randbereiche 145 können sich beispielsweise dort ergeben, wo die Flüssigkeitsschicht an eine feste Begrenzung stößt.

Der Antrieb des Vorratsbehälters 120 für die vorstehend genannte Bewegung in Pfeilrichtung 123 zur Herstellung der Flussmittelschicht 144 erfolgt über einen Antriebsmotor 126, der über eine Antriebsstange 128 den Vorratsbehälter 120 horizontal verschieben kann. Die Antriebsstange 128 kann dabei beispielsweise als Gewindestange oder Zylinder ausgebildet sein, wobei der Antriebsmotor 126 dann ein entsprechend ausgestaltetes, drehbar gelagertes Antriebselement umfassen kann.

Die Antriebseinheit 126 ist fest mit einem Tragegestell 110 verbunden, welches als mechanisches Grundgerüst für die Vorrichtung 100 zur Herstellung von Flussmittelschichten dient.

Die Trägerplatte 140 ist höhenverstellbar ausgebildet und entlang eines in Figur 1 dargestellten vertikalen Pfeils 143 gegenüber dem Tragegestell 110 verschiebbar. Die Verschiebung der Trägerplatte 140 erfolgt über eine Antriebseinheit 136, die am Tragegestell 110 befestigt ist. Diese wirkt wiederum über eine Schubstange 138 auf ein Schubelement 130 ein, welches auf diese Weise in eine in Figur 1 eingezeichnete Pfeilrichtung 133 bewegbar ist. Das Schubelement 130 weist eine schräge Kontakt-Fläche auf, welche mit einer entsprechenden schrägen weiteren Kontakt-Fläche eines Hubelements 142 in Kontakt steht, wobei das Hubelement 142 mit der Trägerplatte 140 fest verbunden ist.

Bei der Bewegung des Schubelements 130 in Pfeilrichtung 133 gleiten die genannten Kontakt-Flächen des Schubelements 130 und des Hubelements 142 aneinander vorbei, so dass dabei eine entsprechende vertikale Bewegung des Hubelements 142 und damit auch der Trägerplatte 140 in einer in Figur 1 dargestellten Pfeilrichtung 143 erzeugt wird. Dabei erzeugt eine Bewegung des Schubelements 130 nach rechts in Figur 1 ein Anheben der Trägerplatte 140 und eine entsprechende Bewegung des Schubelements 130 nach links in Figur 1 ein Absenken der Trägerplatte 140.

Zum Herstellen einer Flüssigkeitsschicht 144 der Dicke d1 wird das Schubelement 130 derart verfahren, dass die Oberfläche der Trägerplatte 140 einen Abstand von d2 zur Unterkante des Flüssigkeitsbehälters 120 aufweist, wie in Figur 1 dargestellt. Der für die Schichtdicke d1 relevante und damit hier betrachtete Abstand zwischen der Unterkante des Flüssigkeitsbehälters 120 und der Oberfläche der Flüssigkeits-Trägerplatte 140 ist dabei die Höhendifferenz d2 zwischen der Unterkante des Flüssigkeitsbehälters 120 und der Oberfläche der Flüssigkeits-Trägerplatte 140. Der Zusammenhang zwischen der Höhendifferenz d2 und der Schichtdicke d1 kann dabei z.B. durch eine Versuchsreihe ermittelt, geschätzt oder analytisch berechnet werden.

Danach wird der Flüssigkeitsbehälter 120 mittels der Antriebseinheit 126 in Figur 1 in Pfeilrichtung 123 nach rechts vollständig über die Trägerplatte 140 bewegt und dann wieder zurück in die in Figur 1 eingezeichnete Ausgangsstellung gefahren. Während dieser Bewegung tritt Flussmittel 124 unten aus dem Flüssigkeitsbehälter 120 aus und wird auf der Oberfläche der Flüssigkeits-Trägerplatte 140 deponiert. Danach ist die Flussmittelschicht 144 mit der Dicke d1 auf der Oberfläche der Trägerplatte 140 hergestellt.

Anschließend kann z. B. ein entsprechendes elektronisches Bauelement mit metallischen Kontakten an die Flüssigkeits-schicht 144 herangeführt und die Kontakte darin eingetaucht werden, bevor das Bauelement dann beispielsweise auf eine Leiterplatte gesetzt und dann verlötet wird.

Der in der vorliegenden Beschreibung erwähnte Hubmechanismus der Vorrichtung zur Herstellung von Flüssigkeitsschichten kann im vorliegenden Beispiel beispielsweise das Schubelement 130, das Hubelement 142, sowie die Antriebseinheit 136 für das Schubelement 130 und die zur Bewegung des Schubelements verwendete Antriebsstange 138 umfassen.

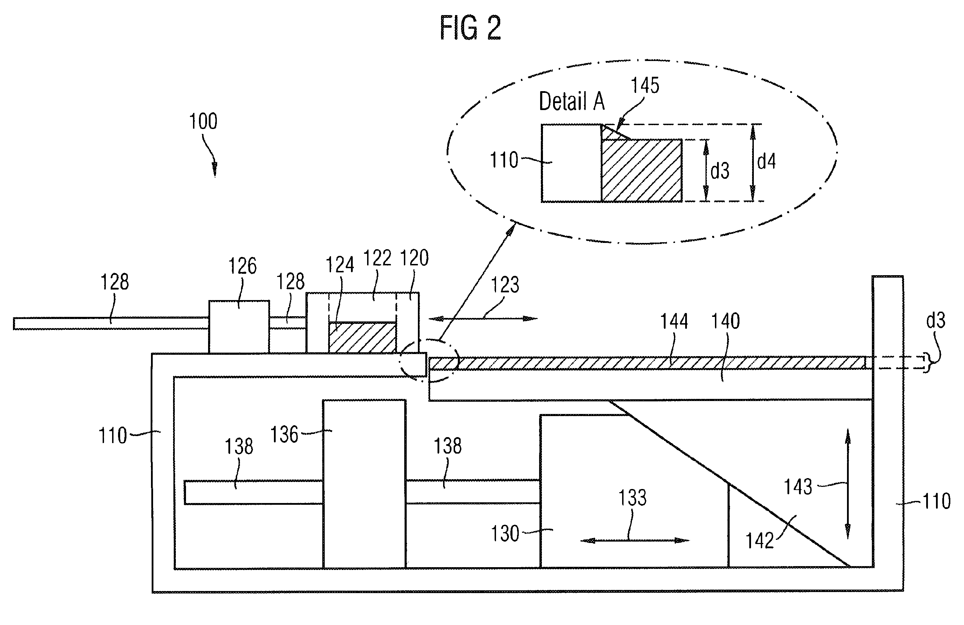

Figur 2 stellt die in Figur 1 dargestellte Vorrichtung zur Herstellung von Flussmittelschichten mit einer Einstellung für die Herstellung einer Flüssigkeitsschicht mit einer anderen Dicke d3 dar. Die Bezugszeichen der Vorrichtung 100 in Figur 2 entsprechen denen der Vorrichtung in Figur 1.

Bei der in Figur 2 dargestellten Konfiguration der Vorrichtung zur Herstellung von Flussmittelschichten 100 wurde die vertikale Lage der Trägerplatte 140 über den Hubmechanismus 136, 138, 130, 142 derart eingestellt, dass eine Flussmittelschicht der Dicke d2 gebildet wird. Dazu wurde gegenüber der Konfiguration in Figur 1 das Schubelement 130 über die Antriebseinheit 136 in Figur 2 ein Stück nach links bewegt, was ein Absenken des Hubelements 142 und der damit verbundenen Trägerplatte 140 um einen entsprechenden Betrag bewirkt. Das Absenken erfolgte derart, dass der Abstand der Oberfläche der Trägerplatte 140 zur Unterkante des Flüssigkeitsbehälters 120 einem Wert d4 entspricht, der größer als d3 ist. Auch hier kann der Zusammenhang zwischen der Höhendifferenz d4 und der Schichtdicke d3 beispielsweise durch eine Versuchsreihe ermittelt, geschätzt oder analytisch berechnet werden.

Danach wurde die Flussmittelschicht 144 durch eine entsprechende horizontale Bewegung in der Richtung 123 des Flüssigkeitsbehälters 120 entsprechend der zu Figur 1 gegebenen Beschreibung erzeugt.

Wie in Figur 2 erkennbar, handelt es sich bei der eingezeichneten Schichtdicke d3 um die maximale, mit der Vorrichtung erzielbare Dicke der Flussmittelschicht 144, da bei der eingezeichneten Stellung das Hubelement 142 auf der Trägereinheit aufsitzt. Daher lassen sich mit der Vorrichtung 100 Flussmittelschichten mit beliebigen Dicken zwischen dem Wert d3, der in Figur 2 dargestellt ist einstellen. Der Wert 0 wird erreicht, wenn die Oberfläche der Trägerplatte 140 auf gleicher Höhe wie die Unterkante des Flüssigkeitsbehälters 120 ist liegt.

Auf diese Weise wird eine sehr flexible Einstellung der Vorrichtung 100 zum Herstellen von Flussmittelschichten an die verschiedensten elektronischen Bauelemente mit unterschiedlich langen oder ausgestalteten Kontakten ermöglicht.

Die vorstehend beschriebene Vorrichtung zur Herstellung von Flüssigkeitsschichten mit vorbestimmter Dicke auf einem Träger ermöglicht über die Einstellung der Lage einer Flüssigkeits-Trägerplatte über einen entsprechenden Hubmechanismus die sehr flexible Anpassung der Dicke einer hergestellten Flüssigkeitsschicht an verschiedene Anwendungen, wie z.B. jeweils mit der Flüssigkeitsschicht zu verwendende Elemente. Solche Elemente können mittels der Vorrichtung zum Herstellen von Flüssigkeitsschichten z. B. mit Klebstoffen, Haftmitteln, Flussmitteln, Lotpasten oder ähnlichen Flüssigkeiten benetzt werden. Die flexible Anpassbarkeit kann beispielsweise dadurch erreicht werden, dass die Dicke einer erzeugten Flüssigkeitsschicht in einem bestimmten Bereich kontinuierlich einstellbar ist und sehr flexibel an die genaue Ausgestaltung und geometrische Form eines entsprechenden Elements anpassbar ist.

## Patentansprüche

1. Vorrichtung (100) zur Herstellung von Flüssigkeitsschichten mit vorbestimmter Dicke auf einem Träger, umfassend
- eine Flüssigkeits-Trägerplatte (140),
- einen Flüssigkeitsbehälter (120), der zum Aufbringen einer Flüssigkeitsschicht (144) auf einer Oberfläche der Flüssigkeits-Trägerplatte (140) über die Flüssigkeits-Trägerplatte (140) bewegbar ist oder bewegt wird, **dadurch gekennzeichnet,**
**dass** ein Hubmechanismus (130, 136, 138, 142) vorgesehen ist, mit welchem die Oberfläche der Flüssigkeits-Trägerplatte (140) relativ zu einem Flüssigkeitsbehälter (120), insbesondere zu einer Unterkante des Flüssigkeitsbehälters (120), verschiebbar ist, und
**dass** diese Verschiebung eine Bewegungskomponente senkrecht zur Oberfläche der Flüssigkeits-Trägerplatte (140) aufweist, insbesondere dass diese Verschiebung im Wesentlichen senkrecht zur Oberfläche der Flüssigkeits-Trägerplatte (140) verläuft.

2. Vorrichtung gemäß Anspruch 1,
**dadurch gekennzeichnet,**
**dass** eine Dicke (d1, d3) der aufzubringenden Flüssigkeitsschicht (144) mittels des Hubmechanismus (130, 136, 138, 142) zwischen einem vorgegebenen oder vorgebbaren minimalen und maximalen Dickenwerts kontinuierliche einstellbar ist oder eingestellt wird.

3. Vorrichtung gemäß Anspruch 1 oder 2,
**dadurch gekennzeichnet,**
**dass** die Flüssigkeits-Trägerplatte (140) keine vertikal über die Oberfläche hinausragenden Seitenelemente zur Begrenzung der aufgebrachten oder aufzubringenden Flüssigkeitsschicht (144) aufweist.

4. Vorrichtung gemäß einem der Ansprüche 1 bis 3,
**dadurch gekennzeichnet,**
**dass** die Vorrichtung ein Basiselement (110), insbesondere zum Befestigen der Vorrichtung (100) an einem Träger oder einer Basiseinheit eines Bestückautomaten, umfasst.

5. Vorrichtung gemäß einem der Ansprüche 1 bis 4,
**dadurch gekennzeichnet,**
**dass** der Hubmechanismus (130, 136, 138, 142) eine Antriebseinheit (136) zur Bewegung der Flüssigkeits-Trägerplatte (140) umfasst.

6. Vorrichtung gemäß Anspruch 5,
**dadurch gekennzeichnet,**
**dass** der Hubmechanismus (130, 136, 138, 142) weiterhin ein durch die Antriebseinheit (136) angetriebenes erstes Antriebselement (130) und ein an der Flüssigkeits-Trägerplatte (140) befindliches zweites Antriebselement (142) umfasst,
wobei das erste Antriebselement (130) zur Bewegung der Flüssigkeits-Trägerplatte (140) mit dem zweiten Antriebeselement (142) zusammenwirkt.

7. Vorrichtung gemäß Anspruch 6,
**dadurch gekennzeichnet,**
**dass** das erste Antriebselement (130) zur Bewegung der Flüssigkeits-Trägerplatte (140) im Wesentlichen parallel zu der Oberfläche der Flüssigkeits-Trägerplatte (140) bewegt wird oder bewegbar ist.

8. Vorrichtung gemäß Anspruch 6 oder 7,
**dadurch gekennzeichnet,**
**dass** das erste und zweite Antriebselement (130, 142) jeweils eine winklig zur Oberfläche der Flüssigkeits-Trägerplatte orientierte Gleitfläche aufweist, wobei die Gleitflächen der Antriebselemente (130, 142) derart angeordnet und ausgestaltet sind, dass sie sich bei einer Bewegung der Flüssigkeits-Trägerplatte (142) durch die Antriebseinheit (136) aneinander vorbei bewegen.

9. Bestückautomat zum Bestücken von elektrischen und/oder optischen Bauteilen auf Substrate, umfassend
- einen Greifer zum Aufnehmen von elektrischen und/oder optischen Bauteilen aus einem Zuführbereich des Bestückautomaten und zum Absetzen der Bauteile auf einem Substrat, und
- eine Vorrichtung (100) zur Herstellung von Flüssigkeitsschichten gemäß einem der Ansprüche 1 bis 8,
wobei der Bestückautomat derart ausgebildet und eingerichtet ist, dass zumindest Kontaktabschnitte der Bauteile nach dem Aufnehmen der Bauteile aus dem Zuführbereich und vor dem Absetzen auf dem Substrat unter Verwendung der Vorrichtung (100) zur Herstellung von Flüssigkeitsschichten mit der Flüssigkeit benetzt werden oder benetzbar sind.

10. Bestückautomat gemäß Anspruch 9,
**dadurch gekennzeichnet,**
**dass** die Vorrichtung (100) zur Herstellung von Flüssigkeitsschichten zumindest teilweise in dem Zuführbereich oder an den Zuführbereich angrenzend angeordnet ist.

11. Verfahren zur Herstellung einer Flüssigkeitsschicht mit einer Vorrichtung (100) gemäß einem der Ansprüche 1 bis 8, bestehend aus den Schritten:
- einstellen einer Dicke (d1, d3) einer aufzubringenden Flüssigkeitsschicht (144) mit dem Hubmechanismus (130, 136, 138, 142),
- aufbringen der Flüssigkeitsschicht (144).

12. Verfahren gemäß Anspruch 11,
**dadurch gekennzeichnet,**
**dass** die Dicke (d1, d3) der aufzubringenden Flüssigkeitsschicht (144) durch den Abstand (d2, d4) der Unterkante des Flüssigkeitsbehälters (120) zu der Oberfläche der Flüssigkeits-Trägerplatte (140) vorgegeben oder vorgebbar ist.

13. Verfahren gemäß Anspruch 11 oder 12,
**dadurch gekennzeichnet,**
**dass** zum Aufbringen der Flüssigkeitsschicht (144) der Flüssigkeitsbehälter (120) über die Flüssigkeits-Trägerplatte (140) bewegt wird.

14. Verfahren zum Bestücken von elektrischen und/oder optischen Bauteilen unter Verwendung eines Bestückautomaten gemäß Anspruch 9 oder 10, bestehend aus den Schritten:
- einstellen einer Dicke (d1, d3) einer aufzubringenden Flüssigkeitsschicht (144) mit dem Hubmechanismus (130, 136, 138, 142),
- aufbringen der Flüssigkeitsschicht (144),
- eintauchen zumindest von Kontaktflächen eines mit dem Greifer aus dem Zuführbereich aufgenommenen Bauelements in die Flüssigkeitsschicht (144),
- absetzen des Bauelements auf einem zu bestückenden Substrat.

15. Verfahren gemäß Anspruch 14,
**dadurch gekennzeichnet,**
**dass** die Dicke (d1, d3) der aufzubringenden Flüssigkeitsschicht (144) durch den Abstand (d2, d4) der Unterkante des Flüssigkeitsbehälters (120) zu der Oberfläche der Flüssigkeits-Trägerplatte (140) vorgegeben oder vorgebbar ist.

16. Verfahren gemäß Anspruch 14 oder 15,
**dadurch gekennzeichnet,**
**dass** zum Aufbringen der Flüssigkeitsschicht (144) der Flüssigkeitsbehälter (120) über die Flüssigkeits-Trägerplatte (140) bewegt wird.

## Claims

1. Apparatus (100) for manufacturing fluid layers with a prespecified thickness on a framework, comprising
- a fluid carrier plate (140),
- a fluid container (120), which is able to be moved or is moved over a carrier plate (140) for applying a layer of fluid (144) to a surface of the fluid carrier plate (140),
**characterised in that**
a lifting mechanism (130, 136, 138, 142) is provided, with which the surface of the fluid carrier plate (140) is able to be displaced relative to a fluid container (120), especially relative to a lower edge of the fluid container (120), and this displacement comprises a displacement component at right angles to the surface of the fluid carrier plate (140), especially that this displacement runs substantially at right angles to the surface of the fluid carrier plate (140).

2. The apparatus according to claim 1,
**characterised in that**
a thickness (d1, d3) of the fluid layer to be applied (144) is able to be set or is set continuously by the lifting mechanism (130, 136, 138, 142) between a prespecified or prespecifiable minimum and maximum thickness value.

3. Apparatus according to claim 1 or 2,
**characterised in that**
the fluid carrier plate (140) does not have any lateral elements projecting vertically over the surface for limiting the fluid layer (144) applied or to be applied.

4. Apparatus according to claims 1 to 3,
**characterised in that** the device includes a base element (110), especially for attaching the apparatus (100) to a carrier or a base unit of an automatic component placement device.

5. Apparatus according to one of claims 1 to 4,
**characterised in that**
the lifting mechanism (130, 136, 138, 142) includes a drive unit (136) for moving the fluid carrier plate (140).

6. Apparatus according to claim 5,
**characterised in that**
the lifting mechanism (130, 136, 138, 142) further includes a first drive element (130) driven by the drive unit (136) and a second drive element (142) located on the fluid carrier plate (140)
with the first drive element (130) interacting with the second drive element (142) to move the fluid carrier plate (140).

7. Apparatus according to claim 6,
**characterised in that**
to move the fluid carrier plate (140), the first drive element (130) is moved or is able to be moved substantially in parallel to the surface of the fluid carrier plate (140).

8. Apparatus according to claim 6 or 7,
**characterised in that**
the first and second drive elements (130, 142) each feature a sliding surface arranged inclined to the surface of the fluid carrier plate, with the sliding surfaces of the drive elements (130, 142) being arranged and embodied such that they move past one another when the fluid carrier plate (142) is moved by the drive unit (136).

9. An automatic component placement device for picking and placing electrical and/or optical components on substrates, comprising
- a gripper for picking up electrical and/or optical components from a feed area of the automatic component placement device and for placing the components on a substrate, and
- a facility (100) for manufacturing fluid layers in accordance with one of claims 1 to 8, with the automatic component placement device being embodied such that at least contact sections of the components are wetted or are able to be wetted with the fluid using the facility (100) after the components are picked up from the feed area and before they are placed on the substrate.

10. Automatic component placement device according to claim 9,
**characterised in that**
the apparatus (100) for manufacturing fluid layers is arranged at least partly in the feed area or adjacent to the feed area.

11. Method for manufacturing a fluid layer with a facility (100) according to one of claims 1 to 8, comprising the following steps:
- setting a thickness (d1, d3) with the lift mechanism (130, 136, 138, 142) of a layer of fluid to be applied (144),
- applying the fluid layer (144).

12. Method according to claim 11,
**characterised in that**
the thickness (d1, d3) of the fluid layer to be applied (144) is predetermined or able to be predetermined by the distance (d2, d4) between the lower edge of the fluid container (120) and the surface of the fluid carrier plate (140).

13. Method according to claim 11 or 12,
**characterised in that**
the fluid container (120) is moved over the fluid carrier plate (140) in order to apply the fluid layer (144).

14. Method for picking and placing electronic or optical components using an automatic component placement device according to claim 9 or 10, consisting of the steps:
- setting a thickness (d1, d3) with the lift mechanism (130, 136, 138, 142) of a layer of fluid to be applied (144),
- applying the fluid layer (144),
- dipping at least contact surfaces of a component picked up with the gripper from the feed area into the fluid layer (144),
- placing the component on a substrate to be equipped.

15. Method according to claim 14,
**characterised in that**
the thickness (d1, d3) of the fluid layer to be applied (144) is predetermined or able to be predetermined by the distance (d2, d4) between the lower edge of the fluid container (120) and the surface of the carrier plate (140).

16. Method according to claim 14 or 15,
**characterised in that**
the fluid container (120) is moved over the fluid carrier plate (140) in order to apply the fluid layer (144).

## Revendications

1. Dispositif (100) de fabrication de couches de liquide d'épaisseur prédéfinie sur un support, comprenant
- une plaque support de liquide (140),
- un réservoir de liquide (120) qui peut être déplacé, ou est déplacé au-dessus de la plaque support de liquide (140) pour appliquer une couche de liquide (144) sur une surface de la plaque support de liquide (140),
**caractérisé en ce que**
un mécanisme de levage (130, 136, 138, 142) est prévu, au moyen duquel la surface de la plaque support de liquide (140) peut être décalée par rapport à un réservoir de liquide (120), plus particulièrement à un bord inférieur du réservoir de liquide (120), et **en ce que**
ce décalage présente une composante de mouvement perpendiculaire à la surface de la plaque support de liquide (140), en particulier **en ce que** ce décalage est essentiellement perpendiculaire à la surface de la plaque support de liquide (140).

2. Dispositif selon la revendication 1,
**caractérisé en ce que**
une épaisseur (d1, d3) de la couche de liquide (144) à appliquer peut être réglée, ou est réglée continuellement au moyen du mécanisme de levage (130, 136, 138, 142) entre une valeur d'épaisseur minimale et maximale prédéfinie ou prédéfinissable.

3. Dispositif selon la revendication 1 ou 2,
**caractérisé en ce que**
la plaque support de liquide (140) est dépourvue d'éléments latéraux dépassant verticalement la surface pour limiter la couche de liquide (144) appliquée ou à appliquer.

4. Dispositif selon l'une des revendications 1 à 3,
**caractérisé en ce que**
le dispositif comprend un élément de base (110), notamment pour fixer le dispositif (100) sur un support ou une unité de base d'un automate d'équipement.

5. Dispositif selon l'une des revendications 1 à 4,
**caractérisé en ce que**
le mécanisme de levage (130, 136, 138, 142) comprend une unité d'entraînement (136) permettant le mouvement de la plaque support de liquide (140).

6. Dispositif selon la revendication 5,
**caractérisé en ce que**
le mécanisme de levage (130, 136, 138, 142) comprend en outre un premier élément d'entraînement (130) entraîné par l'unité d'entraînement (136), et un second élément d'entraînement (142) situé sur la plaque support de liquide (140),
le premier élément d'entraînement (130) coopérant avec le second élément d'entraînement (142) pour permettre le mouvement de la plaque support de liquide (140).

7. Dispositif selon la revendication 6,
**caractérisé en ce que**
pour permettre le mouvement de la plaque support de liquide (140), le premier élément d'entraînement (130) est déplacé, ou peut être déplacé sensiblement parallèlement à la surface de la plaque support de liquide (140).

8. Dispositif selon la revendication 6 ou 7,
**caractérisé en ce que**
le premier et second élément d'entraînement (130, 142) présentent chacun une surface de glissement d'orientation angulaire par rapport à la surface de ladite plaque support de liquide, les surfaces de glissement des éléments d'entrainement (130, 142) étant disposées et configurées de telle façon qu'elles se déplacent l'une devant l'autre lors d'un mouvement de la plaque support de liquide (142) provoqué par l'unité d'entraînement (136).

9. Automate d'équipement pour placer des composants électriques et/ou optiques sur un substrat, comprenant
- une pince destinée à saisir des composants électriques et/ou optiques dans une zone d'alimentation dudit automate d'équipement et à déposer les composants sur un substrat, et
- un dispositif (100) de fabrication de couches de liquide selon l'une des revendications 1 à 8,
ledit automate d'équipement étant réalisé et adapté de telle façon que, après avoir saisi les composants dans la zone d'alimentation et avant de les déposer sur le substrat, au moins des portions de contacts desdits composants soient humectées, ou puissent être humectées avec le liquide au moyen du dispositif (100) de fabrication de couches de liquide.

10. Automate d'équipement selon la revendication 9,
**caractérisé en ce que**
le dispositif (100) de fabrication de couches de liquide est disposé, au moins partiellement, dans la zone d'alimentation ou aux confins de la zone d'alimentation.

11. Procédé de fabrication d'une couche de liquide au moyen d'un dispositif (100) selon l'une des revendications 1 à 8, composé des étapes :
- régler au moyen du mécanisme de levage (130, 136, 138, 142), une épaisseur (d1, d3) d'une couche de liquide (144) à appliquer,
- appliquer la couche de liquide (144).

12. Procédé selon la revendication 11,
**caractérisé en ce que**
l'épaisseur (d1, d3) de la couche de liquide (144) à appliquer est prédéfinie, ou peut être prédéfinie par la distance (d2, d4) du bord inférieur du réservoir de liquide (120) par rapport à la surface de la plaque support de liquide (140).

13. Procédé selon la revendication 11 ou 12,
**caractérisé en ce que**
pour appliquer la couche de liquide (144), le réservoir de liquide (120) est déplacé au-dessus de la plaque support de liquide (140).

14. Procédé pour placer des composants électriques et/ou optiques au moyen d'un automate d'équipement selon la revendication 9 ou 10, composé des étapes :
- régler au moyen du mécanisme de levage (130, 136, 138, 142), une épaisseur (d1, d3) d'une couche de liquide (144) à appliquer,
- appliquer la couche de liquide (144),
- plonger dans la couche de liquide (144) au moins des surfaces de contacts d'un composant, saisi avec la pince dans la zone d'alimentation,
- déposer le composant sur un substrat à équiper.

15. Procédé selon la revendication 14,
**caractérisé en ce que**
l'épaisseur (d1, d3) de la couche de liquide (144) à appliquer est prédéfinie, ou peut être prédéfinie par la distance (d2, d4) du bord inférieur du réservoir de liquide (120) par rapport à la surface de la plaque support de liquide (140).

16. Procédé selon la revendication 14 ou 15,
**caractérisé en ce que**
pour appliquer la couche de liquide (144), le réservoir de liquide (120) est déplacé au-dessus de la plaque support de liquide (140).
